# EUROPEAN PATENT APPLICATION

(11) **EP 4 539 631 A1**
(43) Date of publication of application: **16.04.2025**
(21) Application number: 24205237.1
(22) Date of filing: 08.10.2024
(51) Int. Cl.: H10D 30/69, H10B 51/30

(54) **SEMICONDUCTOR DEVICE, AND MEMORY APPARATUS AND ELECTRONIC APPARATUS INCLUDING THE SEMICONDUCTOR DEVICE**

(30) Priority: 13.10.2023 KR 20230137033
(71) Applicant: SAMSUNG ELECTRONICS CO., LTD., Yeongtong-gu Suwon-si, Gyeonggi-do 16677 (KR)
(72) Inventor: NAM, Seunggeol, 16678 Suwon-si (KR); YOO, Sijung, 16678 Suwon-si (KR); LEE, Minhyun, 16678 Suwon-si (KR); LEE, Hyunjae, 16678 Suwon-si (KR); CHOI, Seokhoon, 16678 Suwon-si (KR)
(74) Representative: Elkington and Fife LLP

(57) **Abstract**

A semiconductor device, and a memory apparatus and an electronic apparatus including the same are provided. The semiconductor device may include a gate electrode, a ferroelectric layer on the gate electrode, a channel layer on the ferroelectric layer, and a plurality of nanostructures spaced apart from each other in the ferroelectric layer. The plurality of nanostructures may be adjacent to the gate electrode or the channel layer, or a portion of the plurality of nanostructures may be adjacent to the gate electrode and the rest portion of the plurality of nanostructures may be adjacent to the channel layer.

## Description

### FIELD OF THE INVENTION

The disclosure relates to a semiconductor device, and a memory apparatus and an electronic apparatus including the same.

### BACKGROUND OF THE INVENTION

As hard disks are replaced by solid state drives (SSDs), NAND flash memory apparatuses, a non-volatile memory apparatus, may be widely commercialized. Recently, with miniaturization and high integration, vertical NAND flash memory apparatuses in which multiple memory cells are stacked in a direction perpendicular to a substrate are being developed.

Recently, research is being conducted to apply a ferroelectric field-effect transistor (FeFET), which may have a low operating voltage and a fast programming speed, to vertical NAND flash memory apparatuses. A FeFET is a semiconductor device for realizing memory characteristics by using a ferroelectric material as a gate insulating film. In a FeFET, a threshold voltage may be adjusted according to the polarization direction of the ferroelectric material.

### SUMMARY OF THE INVENTION

Provided are a semiconductor device, and a memory apparatus and an electronic apparatus including the same.

Additional aspects will be set forth in part in the description which follows and, in part, will be apparent from the description, or may be learned by practice of the presented embodiments of the disclosure.

According to an embodiment of the disclosure, a semiconductor device may include a gate electrode, a ferroelectric layer on the gate electrode, a channel layer on the ferroelectric layer, and a plurality of nanostructures spaced apart from each other in the ferroelectric layer. The plurality of nanostructures may be adjacent to the gate electrode or the channel layer, or a portion of the plurality of nanostructures may be adjacent to the gate electrode and the rest portion of the plurality of nanostructures may be adjacent to the channel layer.

In some embodiments, the plurality of nanostructures may be configured to store charges, in response to a voltage being applied to the gate electrode and polarization being formed in the ferroelectric layer.

In some embodiments, a distance between the plurality of nanostructures and an interface of the ferroelectric layer may be 30 % or less of a thickness of the ferroelectric layer. The interface of the ferroelectric layer may be adjacent to the gate electrode, the channel layer, or both the gate electrode and the channel layer.

In some embodiments, a band gap of a material of the plurality of nanostructures may be lower than a band gap of a material of the ferroelectric layer.

In some embodiments, the plurality of nanostructures may include an oxide of an element different from the material of the ferroelectric layer or a nitride of the element different from the material of the ferroelectric layer.

In some embodiments, the plurality of nanostructures may include at least one of AIN, GaN, GeN, SiN, CN, InN, YN, ScN, and ZrN.

In some embodiments, a material of the plurality of nanostructures may have a trap density greater than 1×10¹⁹/cm³.

In some embodiments, the ferroelectric layer may include at least one of hafnium oxide, zirconium oxide, and hafnium-zirconium oxide. The ferroelectric layer may further include a dopant.

In some embodiments, the semiconductor device may further include a first insulating layer between the gate electrode and the ferroelectric layer, a second insulating layer between the channel layer and the ferroelectric layer, or both the first insulating layer between the gate electrode and the ferroelectric layer and the second insulating layer between the channel layer and the ferroelectric layer.

In some embodiments, the semiconductor device may further include a paraelectric layer in the ferroelectric layer.

According to an embodiment of the disclosure, a memory apparatus may include a substrate, a plurality of gate electrodes stacked in a direction perpendicular to the substrate, a ferroelectric layer on the plurality of gate electrodes, a channel layer on the ferroelectric layer, and a plurality of nanostructures spaced apart from each other in the ferroelectric layer. The plurality of nanostructures may be adjacent to the plurality of gate electrodes or the channel layer, or a portion of the plurality of nanostructures may be adjacent to the plurality of gate electrodes and the rest portion of the plurality of nanostructures may be adjacent to the channel layer.

In some embodiments, a distance between the plurality of nanostructures and an interface of the ferroelectric layer may be 30 % or less of a thickness of the ferroelectric layer. The interface of the ferroelectric layer may be adjacent to the plurality of gate electrodes, the channel layer, or both the plurality of gate electrodes and the channel layer.

In some embodiments, a material of the plurality of nanostructures may have a lower band gap than a material of the ferroelectric layer.

In some embodiments, the plurality of nanostructures may include an oxide of an element different from the material of the ferroelectric layer or a nitride of the element different from the material of the ferroelectric layer.

In some embodiments, a material of the plurality of nanostructures may have a trap density greater than 1×10¹⁹/cm³.

In some embodiments, the ferroelectric layer may include at least one of hafnium oxide, zirconium oxide, and hafnium-zirconium oxide.

In some embodiments, the memory apparatus may further include a first insulating layer between the plurality of gate electrodes and the ferroelectric layer, a second insulating layer between the channel layer and the ferroelectric layer, or both the first insulating layer between the plurality of gate electrodes and the ferroelectric layer and the second insulating layer between the channel layer and the ferroelectric layer.

In some embodiments, the memory apparatus may further include a paraelectric layer in the ferroelectric layer.

According to an embodiment of the disclosure, an electronic apparatus may include the memory apparatus described above.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a cross-sectional view of a semiconductor device according to an embodiment;
FIG. 2 is an enlarged view of portion A of FIG. 1;
FIG. 3A illustrates a state in which a negative (-) voltage is applied to a gate electrode of the semiconductor device illustrated in FIG. 1;
FIG. 3B illustrates a state in which a positive (+) voltage is applied to the gate electrode of the semiconductor device illustrated in FIG. 1;
FIG. 4 is a cross-sectional view of a semiconductor device according to a comparative example;
FIG. 5 is a cross-sectional view of a semiconductor device according to another embodiment;
FIG. 6 is a cross-sectional view of a semiconductor device according to another embodiment;
FIG. 7 is a cross-sectional view of a semiconductor device according to another embodiment;
FIG. 8 is a perspective view schematically illustrating a memory apparatus according to an embodiment;
FIG. 9 is a cross-sectional view of a cell string of the memory apparatus illustrated in FIG. 8;
FIG. 10 is an enlarged view of portion B of FIG. 9;
FIG. 11 is a conceptual diagram schematically illustrating a device architecture that may be applied to an electronic apparatus;
FIG. 12 is a block diagram of a memory system according to an embodiment; and
FIG. 13 is a block diagram illustrating a neuromorphic apparatus and an external device connected thereto, according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C," "at least one of A, B, or C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Hereinafter, embodiments will be described in detail with reference to the attached drawings. In the attached drawings, the same reference numerals refer to the same components, and the size of each component in the drawings may be exaggerated for clarity and convenience of explanation. Meanwhile, the embodiments described below are merely illustrative, and various modifications are possible from these embodiments.

It will also be understood that when an element is referred to as being "on" or "above" another element, the element may be in direct contact with the other element or other intervening elements may be present. The singular forms include the plural forms unless the context clearly indicates otherwise. It should be understood that, when a part "comprises" or "includes" an element in the specification, unless otherwise defined, other elements are not excluded from the part and the part may further include other elements.

The use of the terms "a", "an", and "the" and similar referents in the context of describing the disclosure are to be construed to cover both the singular and the plural. The operations of all methods described herein can be performed in any suitable order unless otherwise indicated herein or otherwise clearly contradicted by context.

In addition, terms such as "... unit", "... module", or the like refer to units that perform at least one function or operation, and the units may be implemented as hardware or software or as a combination of hardware and software.

The connecting lines, or connectors shown in the various figures presented are intended to represent example functional relationships and/or physical or logical couplings between the various elements. It should be noted that many alternative or additional functional relationships, physical connections or logical connections may be present in a practical device.

The use of any and all examples, or example language provided herein, is intended merely to better illuminate the disclosure and does not pose a limitation on the scope of the disclosure unless otherwise claimed.

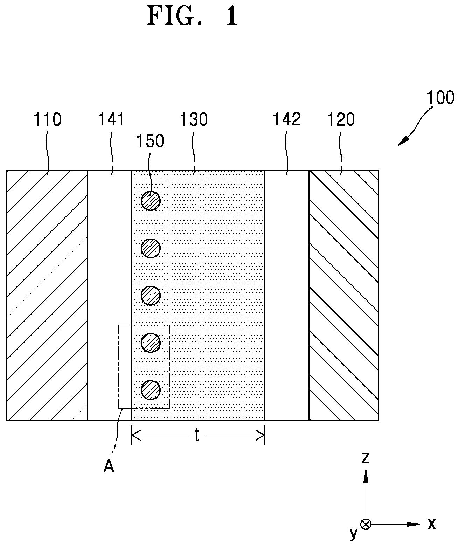

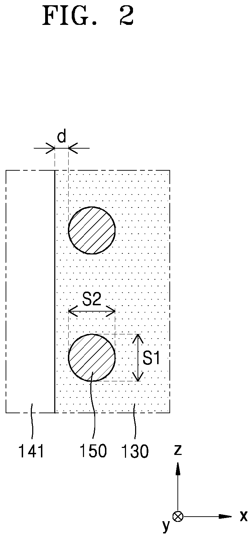

FIG. 1 is a cross-sectional view of a semiconductor device 100 according to an embodiment. The semiconductor device 100 illustrated in FIG. 1 may be, for example, a ferroelectric field-effect transistor (FeFET). FIG. 2 is an enlarged view of portion A of FIG. 1.

Referring to FIGS. 1 and 2, the semiconductor device 100 may include a gate electrode 110, a channel layer 120, and a ferroelectric layer 130 provided between the gate electrode 110 and the channel layer 120. For example, the gate electrode 110 may include a conductive material such as metal, metal nitride, metal oxide, or polysilicon. For an example, the gate electrode 110 may include at least one of W, TiN, TaN, WN, NbN, Mo, Ru, Ir, RuO, IrO, and highly doped poly silicon. However, this is merely an example, and the gate electrode 110 may include various other conductive materials.

The channel layer 120 may include a semiconductor material. For example, the channel layer 120 may include a Group IV semiconductor such as Si, Ge, SiGe, or a Group III-V semiconductor compound. The channel layer 120 may include, for example, an oxide semiconductor, a nitride semiconductor, an oxynitride semiconductor, a two-dimensional (2D) semiconductor material, quantum dots, or an organic semiconductor. Here, the oxide semiconductor may include, for example, InGaZnO, etc., the 2D semiconductor material may include, for example, transition metal dichalcogenide (TMD) or graphene, and the quantum dots may include colloidal quantum dots (colloidal QDs), a nanocrystal structure, etc. However, this is merely an example, and the present embodiment is not limited thereto.

The channel layer 120 may further include a dopant. Here, the dopant may include a p-type dopant or an n-type dopant. The p-type dopant may include, for example, a Group III element such as B, Al, Ga, In, etc., and the n-type dopant may include a Group V element such as P, As, Sb, etc. A source and a drain (not shown) may be provided below and over the channel layer 120, respectively.

The ferroelectric layer 130 is provided between the gate electrode 110 and the channel layer 120. Ferroelectrics have a spontaneous dipole (electric dipole), that is, spontaneous polarization, because the charge distribution within the unit cell is non-centrosymmetric in the crystallized material structure. Additionally, ferroelectrics have remnant polarization due to dipoles even in the absence of an external electric field. Additionally, in ferroelectrics, the direction of polarization may be switched on a domain-by-domain basis by an external electric field.

The ferroelectric layer 130 may include a fluorite-based material. For example, the ferroelectric layer 130 may include at least one oxide selected from Hf, Si, Al, Zr, Y, La, Gd, and Sr. As an example, the ferroelectric layer 130 may include at least one of hafnium oxide (HfO), zirconium oxide (ZrO), and hafnium-zirconium oxide (HfZrO). The ferroelectric layer 130 may further include a dopant. In this case, the dopant may include, for example, at least one of Si, Al, La, Y, Sr, and Gd. But this is merely an example. The ferroelectric layer 130 may have a thickness (t) of, for example, about 4 nm to about 20 nm, but is not limited thereto.

A first insulating layer 141 may be provided between the gate electrode 110 and the ferroelectric layer 130. The first insulating layer 141 may act as a tunneling barrier. The first insulating layer 141 may include, for example, silicon oxide or silicon nitride, but is not limited thereto. Additionally, a second insulating layer 142 may be further provided between the channel layer 120 and the ferroelectric layer 130. Like the first insulating layer 141, the second insulating layer 142 may include, for example, silicon oxide or silicon nitride, but is not limited thereto.

A plurality of nanostructures 150 are provided inside the ferroelectric layer 130. Here, the plurality of nanostructures 150 are provided apart from each other inside the ferroelectric layer 130. The plurality of nanostructures 150 may be configured to store charges of a certain polarity, which have moved from the gate electrode 110 through the first insulating layer 141 by tunneling according to a voltage applied to the gate electrode 110. The plurality of nanostructures 150 may include a material having a lower bandgap than a material of the ferroelectric layer 130. The plurality of nanostructures 150 may include oxide or nitride containing elements different from the material of the ferroelectric layer 130. As an example, the plurality of nanostructures 150 may include at least one of AlN, GaN, GeN, SiN, CN, InN, YN, ScN, and ZrN. However, the disclosure is not limited thereto.

The plurality of nanostructures 150 may include a material having a relatively large trap density. For example, the plurality of nanostructures 150 may include a material having a trap density greater than approximately 1×10¹⁹/cm³. But this is merely an example. Here, the trap density refers to the number of charges trapped in each nanostructure 150 per unit volume.

The plurality of nanostructures 150 may be disposed at distance (d) adjacent to an interface of the ferroelectric layer 130 adjacent to the gate electrode 110, that is, an interface between the first insulating layer 141 and the ferroelectric layer 130. For example, the distance (d) between the plurality of nanostructures 150 and the interface between the first insulating layer 141 and the ferroelectric layer 130 may be approximately 30 % or less of a thickness (t) of the ferroelectric layer 130. As an example, when the thickness (t) of the ferroelectric layer 130 is 10 nm, the distance (d) between the plurality of nanostructures 150 and the interface between the first insulating layer 141 and the ferroelectric layer 130 may be approximately 3 nm or less (e.g., about 1 nm to about 2 nm).

Each of the plurality of nanostructures 150 may have various shapes. For example, each nanostructure 150 may have a spherical shape, an ellipsoid shape, or a rod shape. However, the disclosure is not limited thereto. Each of the plurality of nanostructures 150 may have a nano-level size. In detail, the nanostructure 150 may have a size (S2) of 30 % or less of the thickness (t) of the ferroelectric layer 130 in a thickness direction of the ferroelectric layer 130 (x-axis direction). Additionally, each nanostructure 150 may have a size (S1) of approximately 10 nm or less in the direction parallel to the ferroelectric layer 130 (z-axis direction). The size of the nanostructure 150 described above is merely an example, and the nanostructure 150 may have various sizes. The plurality of nanostructures 150 may be formed through, for example, spinodal decomposition or nucleation and growth.

According to the semiconductor device 100 (FeFET) described above, memory characteristics may be realized by using a ferroelectric material as a gate insulating film and adjusting the threshold voltage according to the polarization direction of the ferroelectric material.

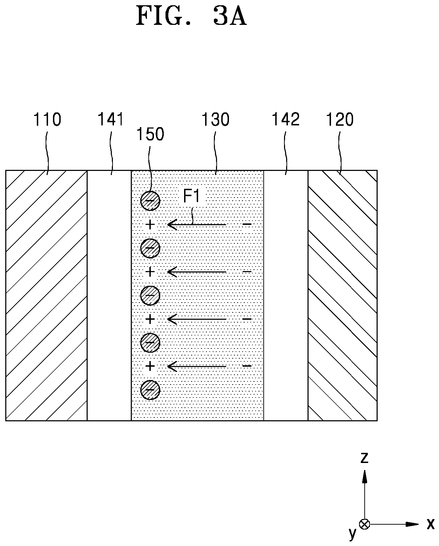

FIG. 3A illustrates a state in which a negative (-) voltage is applied to the gate electrode 110 of the semiconductor device 100 illustrated in FIG. 1. In FIG. 3A, an example of a state in which a negative (-) voltage is applied to the gate electrode 110 for an erase operation of the semiconductor device 100 is illustrated.

Referring to FIG. 3A, when a negative voltage is applied to the gate electrode 110, ferroelectric polarization may be formed in an -x-axis direction F1 inside the ferroelectric layer 130. In order to screen this ferroelectric polarization, negative charges from the gate electrode 110 may pass through the first insulating layer 141 through tunneling and be trapped within the plurality of nanostructures 150.

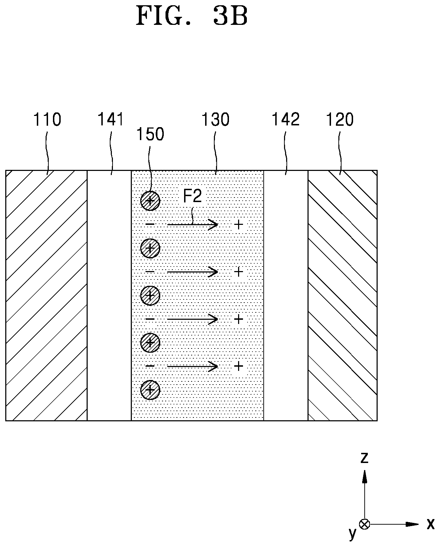

FIG. 3B illustrates a state in which a positive (+) voltage is applied to the gate electrode 110 of the semiconductor device 100 illustrated in FIG. 1. In FIG. 3B, an example of a state in which a positive (+) voltage is applied to the gate electrode 110 for a program operation of the semiconductor device 100 is illustrated.

Referring to FIG. 3B, when a positive voltage is applied to the gate electrode 110, ferroelectric polarization may be formed in an +x-axis direction F2 inside the ferroelectric layer 130. In order to screen this ferroelectric polarization, positive charges from the gate electrode 110 may pass through the first insulating layer 141 through tunneling and be trapped within the plurality of nanostructures 150.

In the semiconductor device 100 according to the embodiment described above, the nanostructures 150 for charge trapping are provided inside the ferroelectric layer 130, and thus the operating voltage does not increase. Additionally, as the nanostructures 150 are located in the same space as the ferroelectric layer 130, the formation of a depolarization field may be limited and/or suppressed. As will be described later, when the semiconductor device 100 is applied to a vertical non-volatile memory apparatus, as the nanostructures 150 are arranged apart from each other inside the ferroelectric layer 130, it becomes difficult for charges, which are trapped in the nanostructures 150, to move, and accordingly, the interference phenomenon or deterioration of retention characteristics due to charge movement between memory cells may be limited and/or suppressed.

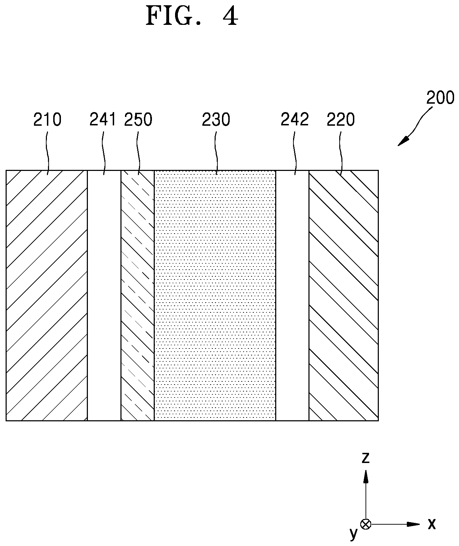

Generally, in semiconductor devices with a metal-ferroelectric-insulator-semiconductor (MFIS) structure, the theoretical maximum value of a memory window (MW) is 2×E_{c}×t_{FE} (where E_{c} is a coercive field and t_{FE} is a thickness of a ferroelectric layer). In order to obtain a memory window larger than a maximum value of the memory window, a structure has been proposed in which a charge trap layer 250 is inserted between a gate electrode 210 and a ferroelectric layer 230, as illustrated in FIG. 4.

FIG. 4 is a cross-sectional view of a semiconductor device 200 according to a comparative example. The semiconductor device 200 illustrated in FIG. 4 is similar to the semiconductor device 100 illustrated in FIG. 1 except that the charge trap layer 250 is provided between the gate electrode 210 and the ferroelectric layer 230. Hereinafter, the description will focus on differences from the semiconductor device 100 illustrated in FIG. 1.

Referring to FIG. 4, the ferroelectric layer 230 is provided between the gate electrode 210 and the channel layer 220. Since the gate electrode 210, the channel layer 220, and the ferroelectric layer 230 have been described above, description thereof will be omitted. A first insulating layer 241 is provided between the gate electrode 210 and the ferroelectric layer 230, and a second insulating layer 242 is provided between the channel layer 220 and the ferroelectric layer 230.

The charge trap layer 250 is provided between the first insulating layer 241 and the ferroelectric layer 230. The charge trap layer 250 may store charges of a certain polarity, which have moved from the gate electrode 210 through the first insulating layer 241 through tunneling according to a voltage applied to the gate electrode 210.

In the semiconductor device 200 illustrated in FIG. 4, a memory window may increase as the number of charges stored in the charge trap layer 250 increases. However, as the charge trap layer 250 is added, the operating voltage of the semiconductor device 200 may increase. In addition, since the charges stored in the charge trap layer 250 are provided apart from the ferroelectric layer 230, a depolarization field increases, and as a result, the amount of ferroelectric polarization decreases, thereby reducing the memory window and causing deterioration of retention characteristics. In addition, when the semiconductor device 200 is applied to a vertical non-volatile memory apparatus, the charges stored in the charge trap layer 250 may move to adjacent memory cells, causing interference between memory cells and deterioration of retention characteristics.

However, as described above, in the semiconductor device 100 according to the embodiment, the nanostructures 150 are provided inside the ferroelectric layer 130, and thus an increase in the operating voltage caused by a separately provided charge trap layer does not occur. Additionally, since the nanostructures 150 are located in the same space as the ferroelectric layer 130, the formation of a depolarization field may be limited and/or suppressed. When the semiconductor device 100 is applied to a vertical non-volatile memory apparatus, as the nanostructures 150 are arranged apart from each other inside the ferroelectric layer 130, it becomes difficult for charges, which are trapped in the nanostructures 150, to move, and accordingly, the interference phenomenon or deterioration of retention characteristics due to charge movement between memory cells may be limited and/or suppressed.

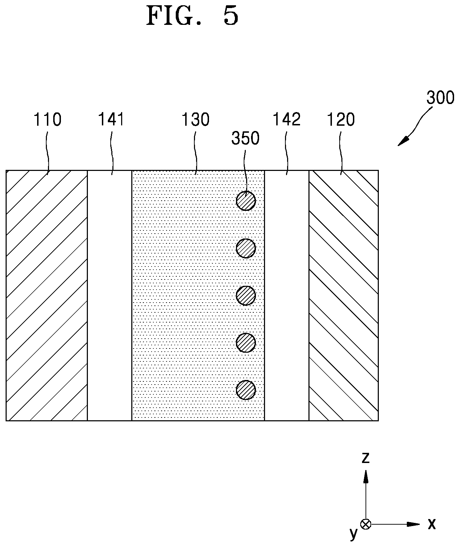

FIG. 5 is a cross-sectional view of a semiconductor device 300 according to an embodiment. Hereinafter, the description will focus on differences from the embodiment described above.

Referring to FIG. 5, the semiconductor device 300 includes a gate electrode 110, a channel layer 120, and a ferroelectric layer 130. Since the gate electrode 110, the channel layer 120, and the ferroelectric layer 130 have been described above, description thereof will be omitted. A first insulating layer 141 may be provided between the gate electrode 110 and the ferroelectric layer 130. Additionally, a second insulating layer 142 may be further provided between the channel layer 120 and the ferroelectric layer 130. The second insulating layer 142 may act as a tunneling barrier.

Inside the ferroelectric layer 130, a plurality of nanostructures 350 are provided apart from each other. The plurality of nanostructures 350 may include a material having a lower bandgap than the material of the ferroelectric layer 130. The plurality of nanostructures 350 may include oxide or nitride containing elements different from the material of the ferroelectric layer 130. As an example, the plurality of nanostructures 350 may include at least one of AlN, GaN, GeN, SiN, CN, InN, YN, ScN, and ZrN. However, the disclosure is not limited thereto. The plurality of nanostructures 350 may include a material having a relatively large trap density. For example, the plurality of nanostructures 350 may include a material having a trap density greater than approximately 1×10¹⁹/cm³. But this is merely an example.

The plurality of nanostructures 350 may be disposed at a distance adjacent to an interface of the ferroelectric layer 130 adjacent to the channel layer 120, that is, an interface between the second insulating layer 142 and the ferroelectric layer 130. For example, a distance between the plurality of nanostructures 350 and the interface between the second insulating layer 142 and the ferroelectric layer 130 may be approximately 30 % or less of a thickness of the ferroelectric layer 130. Each of the plurality of nanostructures 350 may have a spherical shape, an ellipsoid shape, or a rod shape. However, the disclosure is not limited thereto.

In the semiconductor device 300 according to the present embodiment, the plurality of nanostructures 350 may store charges of a certain polarity, which have moved from the channel layer 120 through the second insulating layer 142 by tunneling according to a voltage applied to the gate electrode 110.

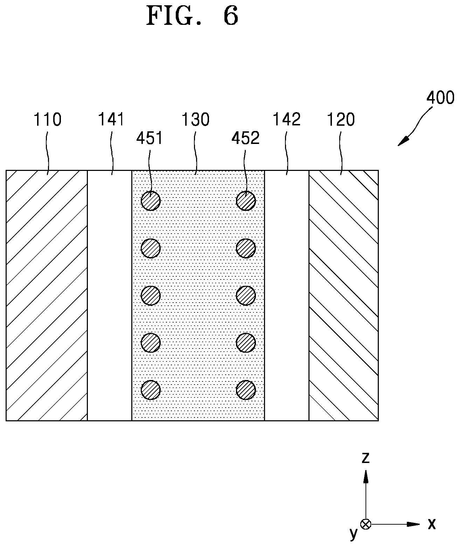

FIG. 6 is a cross-sectional view of a semiconductor device 400 according to another embodiment. Hereinafter, the description will focus on differences from the embodiment described above.

Referring to FIG. 6, the semiconductor device 400 includes a gate electrode 110, a channel layer 120, and a ferroelectric layer 130. A first insulating layer 141 may be provided between the gate electrode 110 and the ferroelectric layer 130, and a second insulating layer 142 may be further provided between the channel layer 120 and the ferroelectric layer 130. Each of the first and second insulating layers 141 and 142 may function as a tunneling barrier.

Inside the ferroelectric layer 130, a plurality of first nanostructures 451 and a plurality of second nanostructures 452 are provided. The first nanostructures 451 may be disposed at distance adjacent to the interface of the ferroelectric layer 130 adjacent to the gate electrode 110, that is, the interface between the first insulating layer 141 and the ferroelectric layer 130. Here, a distance between the plurality of first nanostructures 451 and the interface between the first insulating layer 141 and the ferroelectric layer 130 may be approximately 30 % or less of the thickness of the ferroelectric layer 130. The second nanostructures 452 may be disposed at a distance adjacent to an interface of the ferroelectric layer 130 adjacent to the channel layer 120, that is, an interface between the second insulating layer 142 and the ferroelectric layer 130. Here, the distance between the plurality of second nanostructures 452 and the interface between the second insulating layer 142 and the ferroelectric layer 130 may be approximately 30 % or less of the thickness of the ferroelectric layer 130.

The first and second nanostructures 451 and 452 may each include oxide or nitride containing elements different from the material of the ferroelectric layer 130. As an example, the first and second nanostructures 451 and 452 may each include at least one of AlN, GaN, GeN, SiN, CN, InN, YN, ScN, and ZrN. However, the disclosure is not limited thereto. The first and second nanostructures 451 and 452 may each include a material having a relatively large trap density. For example, the first and second nanostructures 451 and 452 may each include a material having a trap density greater than approximately 1×10¹⁹/cm³, but this is merely an example. Each of the first and second nanostructures 451 and 452 may have, for example, a spherical shape, an ellipsoid shape, or a rod shape. The first and second nanostructures 451 and 452 may include a same material or different materials from each other. While FIG. 6 illustrates an example where the first and second nanostructures 451 and 452 are both spherical, example embodiments are not limited thereto and the first and second nanostructures 451 and 452 in some embodiments may have different shapes from each other.

In the semiconductor device 400 according to the present embodiment, the first nanostructures 451 may store charges of a first polarity, which have moved from the gate electrode 110 through the first insulating layer 141 through tunneling according to a voltage applied to the gate electrode 110, and the second nanostructures 452 may store charges of a second polarity opposite to the first polarity, the charges having moved from the channel layer 120 through the second insulating layer 142 by tunneling.

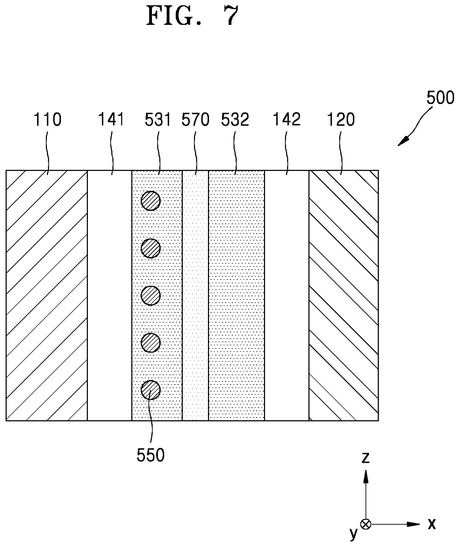

FIG. 7 is a cross-sectional view of a semiconductor device 500 according to another embodiment. Hereinafter, the description will focus on differences from the embodiment described above.

Referring to FIG. 7, a first ferroelectric layer 531, a paraelectric layer 570, and a second ferroelectric layer 532 are provided between the gate electrode 110 and the channel layer 120. Since the first and second ferroelectric layers 531 and 532 are the same as the ferroelectric layers described above, description thereof is omitted. The paraelectric layer 570 may be provided between the first and second ferroelectric layers 531 and 532 to adjust the ferroelectric characteristics of the first and second ferroelectric layers 531 and 532. For example, the paraelectric layer 570 may include at least one of SiO₂, Al₂O₃, La₂O₃, and Y₂O₃. However, this is only an example, and the paraelectric layer 570 may include various other dielectric materials.

A first insulating layer 141 may be provided between the gate electrode 110 and the first ferroelectric layer 531, and a second insulating layer 142 may be provided between the channel layer 120 and the second ferroelectric layer 532. Inside the first ferroelectric layer 531, a plurality of nanostructures 550 are provided apart from each other. The plurality of nanostructures 550 may include a material having a lower bandgap than a material of the first ferroelectric layer 531. The plurality of nanostructures 550 may include oxide or nitride containing an element different from the material of the first ferroelectric layer 531. As an example, the plurality of nanostructures 550 may include at least one of AlN, GaN, GeN, SiN, CN, InN, YN, ScN, and ZrN. However, the disclosure is not limited thereto. The plurality of nanostructures 550 may include a material having a relatively large trap density, for example, a material having a trap density greater than approximately 1×10¹⁹/cm³. But this is merely an example.

The plurality of nanostructures 550 may be disposed at a distance adjacent to an interface of the first ferroelectric layer 531 adjacent to the gate electrode 110, that is, an interface between the first insulating layer 141 and the first ferroelectric layer 531. For example, a distance between the plurality of nanostructures 550 and the interface between the first insulating layer 141 and the first ferroelectric layer 531 may be approximately 30 % or less of a thickness of the first ferroelectric layer 531. Each of the plurality of nanostructures 550 may have, for example, a spherical shape, an ellipsoid shape, or a rod shape, but is not limited thereto.

A case where the plurality of nanostructures 550 are disposed adjacent to the interface between the first insulating layer 141 and the first ferroelectric layer 531 has been described above. However, the disclosure is not limited thereto, and the plurality of nanostructures 550 may be disposed adjacent to an interface between the second insulating layer 142 and the second ferroelectric layer 532. In addition, the plurality of nanostructures 550 may be disposed adjacent to the interface between the first insulating layer 141 and the first ferroelectric layer 531 and the interface between the second insulating layer 142 and the second ferroelectric layer 532.

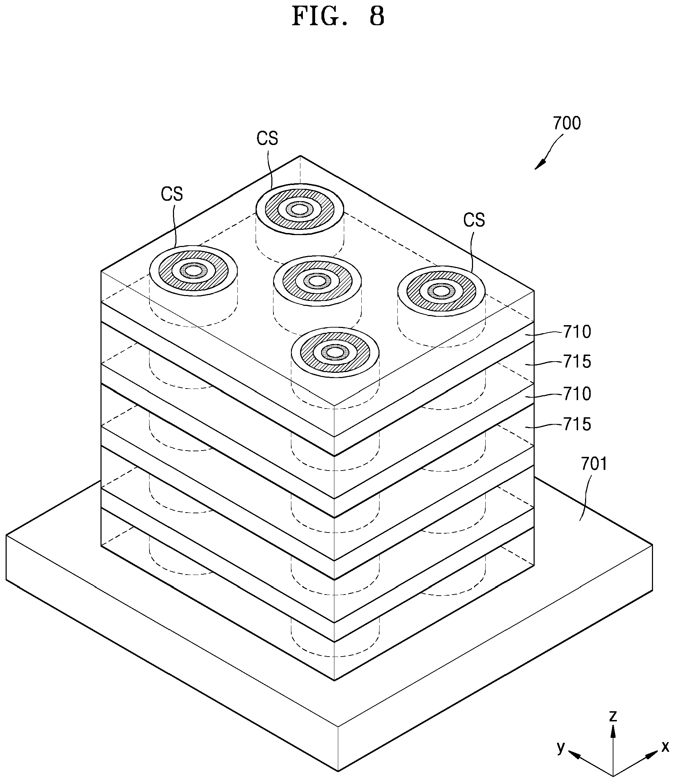

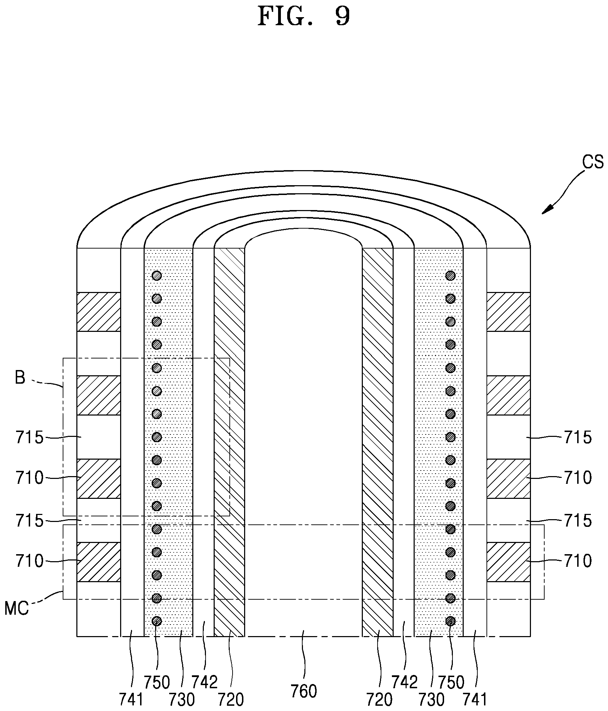

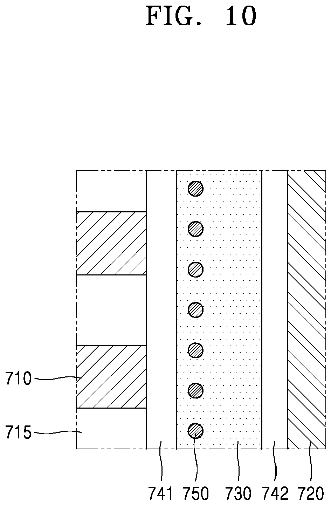

FIG. 8 is a perspective view schematically illustrating a memory apparatus 700 according to an embodiment. The memory apparatus 700 illustrated in FIG. 8 may be a vertical non-volatile memory apparatus. FIG. 9 is a cross-sectional view of a cell string CS of the memory apparatus 700 illustrated in FIG. 8, and FIG. 10 is an enlarged view of portion B of FIG. 9.

Referring to FIGS. 8 to 10, the memory apparatus 700 includes a plurality of cell strings CS disposed on a substrate 701. Here, each cell string CS may be provided to extend in a direction perpendicular to the substrate 701 (z-axis direction). The plurality of cell strings CS may be arranged in various shapes on the substrate 701.

Each cell string CS includes a plurality of memory cells MC stacked in a direction perpendicular to the substrate 701 (z-axis direction). Here, each memory cell MC may include a semiconductor device (FeFET) according to the embodiment described above.

The substrate 701 may include various materials. For example, the substrate 701 may include, but is not limited to, a single crystal silicon substrate, a compound semiconductor substrate, or a silicon on insulator (SOI) substrate. Additionally, the substrate 701 may further include, for example, an impurity region by doping, a peripheral circuit that selects and controls electronic apparatuses such as transistors, or memory cells that store data.

A plurality of gate electrodes 710 are stacked and spaced apart from each other in a direction perpendicular to the substrate 701. Each gate electrode 710 extends in a direction parallel to the substrate 701. The gate electrode 710 controls a corresponding channel layer 720, and a word line may be electrically connected to the gate electrode 710. A voltage that turns on/off the corresponding channel layer 720 may be selectively applied to the gate electrode 710.

For example, the gate electrode 710 may include a conductive material such as metal, metal nitride, metal oxide, or polysilicon. For an example, the gate electrode 710 may include at least one of W, TiN, TaN, WN, NbN, Mo, Ru, Ir, RuO, IrO, and highly doped poly silicon. However, this is merely an example, and the gate electrode 710 may include various other conductive materials.

A plurality of interlayer insulating layers 715 are stacked between the gate electrodes 710 in a direction perpendicular to the substrate 701. The interlayer insulating layer 715 may act as a spacer layer for insulation between the gate electrodes 710. The interlayer insulating layer 715 may include, for example, silicon oxide, silicon nitride, but is not limited thereto.

Inside the gate electrodes 710, a ferroelectric layer 730 and the channel layer 720 are sequentially provided. The ferroelectric layer 730 and the channel layer 720 are each provided to extend perpendicularly to the substrate 701 and may be shared by the plurality of memory cells MC. A source and a drain may be provided at the lower and upper ends of the channel layer 710, and the source and drain may be connected to a common source line and a bit line.

A through hole penetrating the gate electrodes 710 and the interlayer insulating layers 715 is formed in a direction perpendicular to the substrate 701, and this through hole may be formed to have, for example, a circular cross-section. The ferroelectric layer 730 and the channel layer 720 are sequentially provided on an inner wall of the through hole in a direction parallel to the substrate 701. Each of the ferroelectric layer 730 and the channel layer 720 may be formed to have a cylindrical shape extending in a direction perpendicular to the substrate 701.

The channel layer 720 may include a semiconductor material. For example, the channel layer 720 may include a Group IV semiconductor such as Si, Ge, SiGe, or a Group III-V semiconductor compound. The channel layer 720 may include, for example, an oxide semiconductor, a nitride semiconductor, an oxynitride semiconductor, a 2D semiconductor material, quantum dots, or an organic semiconductor. Here, the oxide semiconductor may include, for example, InGaZnO, the 2D semiconductor material may include, for example, TMD or graphene, and the quantum dots may include colloidal quantum dots, nanocrystal structures, etc. However, this is merely an example, and the present embodiment is not limited thereto.

The channel layer 720 may further include a dopant. Here, the dopant may include a p-type dopant or an n-type dopant. The p-type dopant may include, for example, a Group III element such as B, Al, Ga, In, and the n-type dopant may include a Group V element such as P, As, Sb.

Inside the channel layer 720, a filling insulating layer 760 may be provided to fill the through hole. The filling insulating layer 760 may include, for example, silicon oxide or air, but is not limited thereto.

The ferroelectric layer 730 is provided between the gate electrode 710 and the channel layer 720. The ferroelectric layer 730 may include a fluorite-based material. For example, the ferroelectric layer 730 may include at least one oxide selected from Hf, Si, Al, Zr, Y, La, Gd, and Sr. As an example, the ferroelectric layer 730 may include at least one of hafnium oxide (HfO), zirconium oxide (ZrO), and hafnium-zirconium oxide (HfZrO). The ferroelectric layer 730 may further include a dopant. The dopant may include, for example, at least one of Si, Al, La, Y, Sr, and Gd. But this is merely an example. The ferroelectric layer 730 may have a thickness of, for example, about 4 nm to about 20 nm, but is not limited thereto.

A first insulating layer 741 may be provided between the gate electrode 710 and the ferroelectric layer 730. The first insulating layer 741 may act as a tunneling barrier. The first insulating layer 741 may include, for example, silicon oxide or silicon nitride, but is not limited thereto. Additionally, a second insulating layer 742 may be further provided between the channel layer 720 and the ferroelectric layer 730.

Inside the ferroelectric layer 730, a plurality of nanostructures 750 are provided apart from each other. The plurality of nanostructures 750 may be configured to store charges of a certain polarity, which have moved from the gate electrode 710 through the first insulating layer 741 by tunneling according to a voltage applied to the gate electrode 710. The plurality of nanostructures 750 may include a material having a lower bandgap than the material of the ferroelectric layer 730. The plurality of nanostructures 750 may include oxide or nitride containing elements different from the material of the ferroelectric layer 730. As an example, the plurality of nanostructures 750 may include at least one of AlN, GaN, GeN, SiN, CN, InN, YN, ScN, and ZrN. However, the disclosure is not limited thereto. The plurality of nanostructures 750 may include a material having a relatively large trap density. For example, the plurality of nanostructures 750 may include a material having a trap density greater than approximately 1×10¹⁹/cm³. But this is merely an example.

The plurality of nanostructures 750 may be disposed at a distance adjacent to an interface of the ferroelectric layer 730 adjacent to the gate electrodes 710, that is, an interface between the first insulating layer 741 and the ferroelectric layer 730. For example, a distance between the plurality of nanostructures 750 and the interface between the first insulating layer 741 and the ferroelectric layer 730 may be approximately 30 % or less of a thickness of the ferroelectric layer 730.

Each of the plurality of nanostructures 750 may have various shapes such as a sphere shape, an ellipsoid shape, or a rod shape. Each of the plurality of nanostructures 750 may have a nano-level size. In detail, each nanostructure 750 may have a size of 30 % or less of the thickness of the ferroelectric layer 730 in a thickness direction of the ferroelectric layer 730. Additionally, each nanostructure 750 may have a size of approximately 10 nm or less in a direction parallel to the ferroelectric layer 730. But this is merely an example.

In the memory apparatus 700 according to the embodiment described above, the nanostructures 750 for charge trapping are provided inside the ferroelectric layer 730, and thus the operating voltage does not increase. Since the nanostructures 750 are located in the same space as the ferroelectric layer 730, the formation of a depolarization field may be limited and/or suppressed. In addition, as the nanostructures 750 are arranged apart from each other inside the ferroelectric layer 730, it becomes difficult for charges, which are trapped in the nanostructures 750, to move, and thus, the interference phenomenon and deterioration of retention characteristics due to charge movement between the memory cells MC may be limited and/or suppressed.

A case where the nanostructures 750 are disposed adjacent to the gate electrode 710 has been described above, but the disclosure is not limited thereto, and the nanostructures 750 may also be disposed adjacent to the channel layer 720. Additionally, the nanostructures 750 may be disposed adjacent to the gate electrode 710 and the channel layer 720. A paraelectric layer may be inserted into the ferroelectric layer 730.

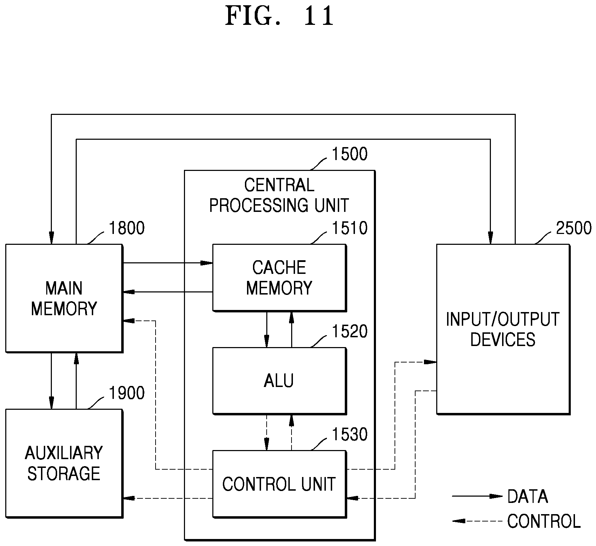

The memory apparatus 700 according to the embodiment described above may be used to store data in various electronic apparatuses. FIG. 11 is a conceptual diagram schematically illustrating a device architecture that may be applied to electronic apparatuses according to embodiments.

Referring to FIG. 11, a cache memory 1510, an arithmetic logic unit (ALU) 1520, and a control unit 1530 may form a central processing unit (CPU) 1500, and the cache memory 1510 may be a static random-access memory (SRAM). Apart from the CPU 1500, a main memory 1800 and an auxiliary storage 1900 may be provided. Input/Output devices 2500 (e.g., keyboard, display) may be provided. The main memory 1800 may include a dynamic random-access memory (DRAM) device, and the auxiliary storage 1900 may include the memory apparatus 700 (vertical non-volatile memory apparatus) described above. In some cases, the device architecture may be implemented in a form where computing unit devices and memory unit devices are adjacent to each other on a single chip, without distinction of sub-units.

The memory apparatus 700 according to the embodiment described above may be implemented as a memory block in the form of a chip and used as a neuromorphic computing platform, or may be used to configure a neural network.

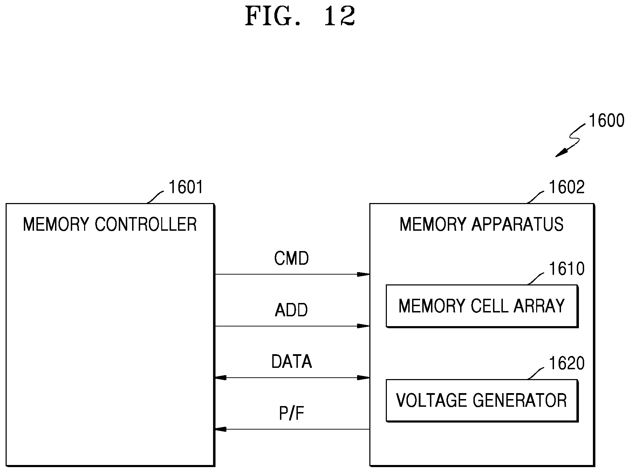

FIG. 12 is a block diagram of a memory system 1600 according to an embodiment.

Referring to FIG. 12, the memory system 1600 may include a memory controller 1601 and a memory apparatus 1602. The memory controller 1601 performs control operations on the memory apparatus 1602, and for example, the memory controller 1601 provides an address ADD to the memory apparatus 1602 and a command CMD to perform programming (or recording), reading and/or erasing operation on the memory apparatus 1602. Additionally, data for programming operations and read data may be transferred between the memory controller 1601 and the memory apparatus 1602.

The memory apparatus 1602 may include a memory cell array 1610 and a voltage generator 1620. The memory cell array 1610 may include a plurality of memory cells and may include the memory apparatus 700 (vertical non-volatile memory apparatus) according to the embodiment described above.

The memory controller 1601 may include processing circuitry, such as hardware including logic circuits; hardware/software combinations, such as processor executing software; or a combination thereof. For example, processing circuits are more specifically central processing unit (CPU), arithmetic logic unit (ALU), digital signal processor, microcomputer, field programmable gate array (FPGA), system-on-chip (SoC), programmable logic unit, microprocessor, application-specific integrated circuit (ASIC), etc., but is not limited thereto. The memory controller 1601 may operate in response to a request from a host (not shown) and may be configured to access the memory apparatus 1602 and control the control operations (e.g., write/read operations) described above so as to convert the memory controller 1601 to a special purpose controller. The memory controller 1601 may generate an address ADD and a command CMD to perform programming/read/erase operations on the memory cell array 1610. Additionally, in response to a command from the memory controller 1601, the voltage generator 1620 (e.g., a power circuit) may generate a voltage control signal for controlling a voltage level of a word line, for programming or reading data on or from the memory cell array 1610.

Additionally, the memory controller 1601 may perform a decision operation on data read from the memory apparatus 1602. For example, from data read from a memory cell, the number of on-cells and/or the number of off-cells may be determined. The memory apparatus 1602 may provide a pass/fail signal P/F to the memory controller 1601 according to a read result of the read data. The memory controller 1601 may control write and read operations of the memory cell array 1610 by referring to the pass/fail signal P/F.

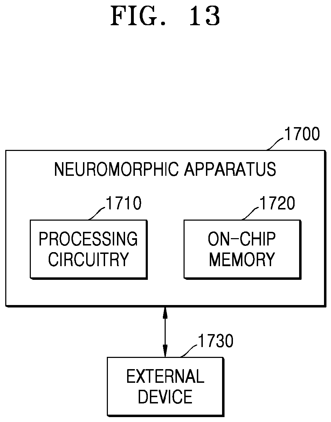

FIG. 13 is a block diagram illustrating a neuromorphic apparatus 1700 and an external device connected thereto, according to an embodiment.

Referring to FIG. 13, the neuromorphic apparatus 1700 may include a processing circuitry 1710 and/or an on-chip memory 1720. The neuromorphic apparatus 1700 may include the memory apparatus 700 (vertical non-volatile memory apparatus) according to the embodiment described above.

In some embodiments, the processing circuitry 1710 may be configured to control functions for driving the neuromorphic apparatus 1700. For example, the processing circuitry 1710 may be configured to control the neuromorphic apparatus 1700 by executing a program stored in the on-chip memory 1720. In some embodiments, the processing circuitry may include hardware such as logic circuitry, a hardware/software combination such as a processor executing software, or a combination thereof. For example, the processor may include a CPU, a graphics processing unit (GPU), an application processor (AP) included in the neuromorphic apparatus 1700, an ALU, a digital signal processor, a microcomputer, a FPGA, a SoC, a programmable logic unit, a microprocessor, ASIC, but is not limited thereto. In some embodiments, the processing circuitry 1710 is configured to read/write various data to the external device 1730 and/or execute the neuromorphic apparatus 1700 by using the read/written data. In some embodiments, the external device 1730 may include an external memory and/or a sensor array with an image sensor (e.g., a complementary metal oxide semiconductor (CMOS) image sensor circuit).

In some embodiments, the neuromorphic apparatus 1700 of FIG. 13 may be applied to a machine learning system. As a machine learning system, various artificial neural network systems and processing models such as a convolutional neural network (CNN), a deconvolutional neural network, a recurrent neural network (RNN) (optionally including a long short-term memory (LSTM) unit and/or a gated recurrent unit (GRU)), a stacked neural network (SNN), a state-space dynamic neural network (SSDNN), a deep belief network (DBN), a generative adversarial network (GAN), and/or a restricted Boltzmann machine (RBM) may be used.

Alternatively or additionally, these machine learning systems may be implemented with other forms of machine learning models, such as linear and/or logistic regression, statistical clustering, Bayesian classification, decision trees, dimensionality reduction such as principal component analysis, expert systems, and/or an ensemble such as random forests or a combination thereof. These machine learning models may be used to provide a variety of services and/or applications, and for example, image classification services, user authentication services based on biometric information or biometric data, Advanced Driver Assistance System (ADAS) services, voice assistant services, automatic speech recognition (ASR) services, etc. may be executed by an electronic apparatus.

In semiconductor devices according to embodiments described above, nanostructures for charge trapping are provided inside a ferroelectric layer, and thus, the operating voltage does not increase, and as the nanostructures are located in the same space as the ferroelectric layer, an increase in a depolarization field may be limited and/or suppressed. When the semiconductor device is applied to a vertical non-volatile memory apparatus, as the nanostructures are arranged apart from each other inside the ferroelectric layer, it becomes difficult for charges trapped in the nanostructures to move to adjacent memory cells, and accordingly, the interference phenomenon and deterioration of retention characteristics due to the charge movement between memory cells may be limited and/or suppressed.

The above has been described with reference to the embodiments illustrated in the drawings, but these are merely examples, and various modifications and other equivalent embodiments may be made therefrom. For example, the nanostructures 150, 350, 451, 452, 550, and 750 described with reference to FIGS. 1, 2, 3A, 3B, 5, 6A, 6B, and 7-9 above may include two or more different types of nanostructures (e.g., first nanostructures and second nanostructures having different materials and/or shapes). Also, while some embodiments such as FIG. 1 illustrate a single column of nanostructures 150, example embodiments are not limited thereto and the nanostructures 150 may be spaced apart from each other in more than one column and/or at varying distances from each other.

One or more of the elements disclosed above may include or be implemented in processing circuitry such as hardware including logic circuits; a hardware/software combination such as a processor executing software; or a combination thereof. For example, the processing circuitry may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a gate electrode;
a ferroelectric layer on the gate electrode;
a channel layer on the ferroelectric layer; and
a plurality of nanostructures spaced apart from each other in the ferroelectric layer, wherein
the plurality of nanostructures are adjacent to the gate electrode or the channel layer, or a portion of the plurality of nanostructures are adjacent to the gate electrode and the rest portion of the plurality of nanostructures are adjacent to the channel layer.

2. The semiconductor device of claim 1, wherein
the plurality of nanostructures are configured to store charges, in response to an voltage being applied to the gate electrode and polarization being formed in the ferroelectric layer.

3. The semiconductor device of claim 1 or 2, wherein
a distance between the plurality of nanostructures and an interface of the ferroelectric layer is 30 % or less of a thickness of the ferroelectric layer, and
the interface of the ferroelectric layer is adjacent to the gate electrode, the channel layer, or both the gate electrode and the channel layer.

4. The semiconductor device of any preceding claim, wherein a band gap of a material of the plurality of nanostructures is lower than a band gap of a material of the ferroelectric layer.

5. The semiconductor device of claim 4, wherein
the plurality of nanostructures comprise an oxide of an element different from the material of the ferroelectric layer or a nitride of an element different from the material of the ferroelectric layer.

6. The semiconductor device of claim 4 or 5, wherein the plurality of nanostructures comprise at least one of AlN, GaN, GeN, SiN, CN, InN, YN, ScN, and ZrN.

7. The semiconductor device of any preceding claim, wherein a material of the plurality of nanostructures has a trap density greater than 1×10¹⁹/cm³.

8. The semiconductor device of any preceding claim, wherein the ferroelectric layer comprises at least one of hafnium oxide, zirconium oxide, and hafnium-zirconium oxide.

9. The semiconductor device of claim 8, wherein the ferroelectric layer further comprises a dopant.

10. The semiconductor device of any preceding claim, further comprising:
a first insulating layer between the gate electrode and the ferroelectric layer,
a second insulating layer between the channel layer and the ferroelectric layer, or
both the first insulating layer between the gate electrode and the ferroelectric layer and the second insulating layer between the channel layer and the ferroelectric layer.

11. The semiconductor device of any preceding claim, further comprising:
a paraelectric layer in the ferroelectric layer.

12. A memory apparatus comprising:
a substrate;
a plurality of semiconductor devices according to any preceding claim

13. An electronic apparatus comprising:
the memory apparatus of claim 12.
